# EUROPEAN PATENT SPECIFICATION

(11) **EP 2 390 676 B1**
(45) Date of publication and mention of the grant of the patent: **11.11.2015**
(21) Application number: 10005569.8
(22) Date of filing: 28.05.2010
(51) Int. Cl.: G01D 5/20

(54) **Electromagnetic coil structure having a flat conductive track, magnetic core and magneto electronic angle sensor**
Elektromagnetische Spulenstruktur mit einer ebenen leitfähigen Spur, Magnetkern und magnetoelektronischer Winkelsensor
Structure de bobine électromagnétique dotée d'une piste conductrice plate, noyau magnétique et capteur d'angle magnéto-électronique

(43) Date of publication of application: 30.11.2011
(73) Proprietor: Tyco Electronics Belgium EC BVBA, 8020 Oostkamp (BE)
(72) Inventor: Ocket, Tom, 8820 Torhout (BE); Mertens, Guus, 9230 Massemen (BE); Van Tomme, Marc, 8800 Roselare (BE); van Cauwenberge, Jan, 9880 Aalter (BE)
(74) Representative: Grünecker Patent- und Rechtsanwälte PartG mbB

(56) References cited:
- DE-A1- 4 233 086
- GB-A- 2 272 110
- JP-A- 2008 089 305
- US-A- 5 300 884

## Description

The present invention relates to a magnetic core with an electromagnetic coil structure for being mounted on the magnetic core. Such a magnetic core is for instance a part of a rotating electric machine or of a magneto electronic angle sensor. The present invention further relates to a magneto electronic angle sensor, in particular a reluctance resolver, having a stator which is constructed according to the principles of the present invention. Furthermore, the present invention relates to a method for fabricating such an angle sensor.

Although the principles of the present invention are applicable for a wide variety of systems using coil structures to be mounted on a magnetic core, in the following mostly the application field of reluctance resolvers will be contemplated. In particular, reluctance resolvers as those shown in the German patent applications DE 10 2010 004887.9 and DE 10 2009 021444.5 can be improved by using the principles according to the present invention.

Reluctance resolvers have an at least partly soft magnetic stator and an at least partly soft magnetic rotor. Rotor and stator are opposed to each other and form an air gap between each other. The reluctance within the air gap changes periodically due to the particular form of the rotor which varies around its circumference.

The angle sensor has a magnetic flux sender arranged at the stator for generating via at least one pole pair a predetermined magnetic flux distribution within the air gap. Furthermore, on the same stator a magnetic flux detector is arranged, which detects the intensity of the magnetic field by means of at least two signal pole pairs being off-set to each other by a predetermined angle. From both detector signals, an angle value can be derived for the relative position of the rotor with respect to the stator.

These magneto electric angle sensors which are based on the principle of a varying magnetic flux intensity in an air gap between the stator and the rotor are known in various forms. Basically, several principles for generating the magnetic flux in the sender part and also different principles for measuring the magnetic field in the detector part are known. Resolvers and so called syncros use electro magnetic coils in the form of primary and secondary windings.

Such resolvers and syncros have the advantage to yield accurate results and to represent very robust angle sensors. In particular, so called reluctance resolvers are known, where the primary as well as the secondary windings are arranged at the stator, whereas the rotor has no windings and thus passively influences the magnetic flux circuit with specially designed magnetically soft parts. By means of an irregular form of the magnetically soft rotor, for instance by providing lobes, the magnetic flux between the primary windings and secondary windings on the stator are influenced differently, thus allowing to derive the angular position of the rotor from the induced voltage.

Several technical concepts exist for fabricating the stator of such a reluctance resolver. Firstly, it is known to wind the windings of the coil directly onto one or more teeth of a magnetic core. On the other hand, as shown for instance in US 5,300,884, it is known to apply the windings onto an electrically insulating coil body and to fit these coil bodies onto the teeth of the magnetic core during assembly. Figures 9 to 11 depict an arrangement according to the principles of the German patent application 10 2010 004887.9. As shown in Figure 9, a stator 202 which is formed from stacked and joint metal sheets has a plurality of teeth 204 whereto coils 206 are to be attached.

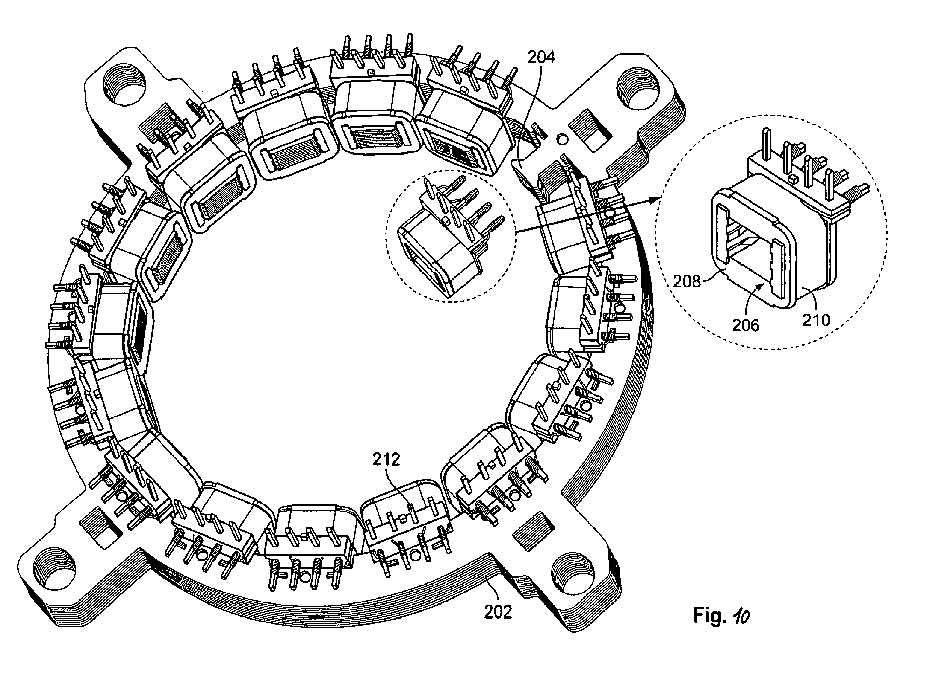

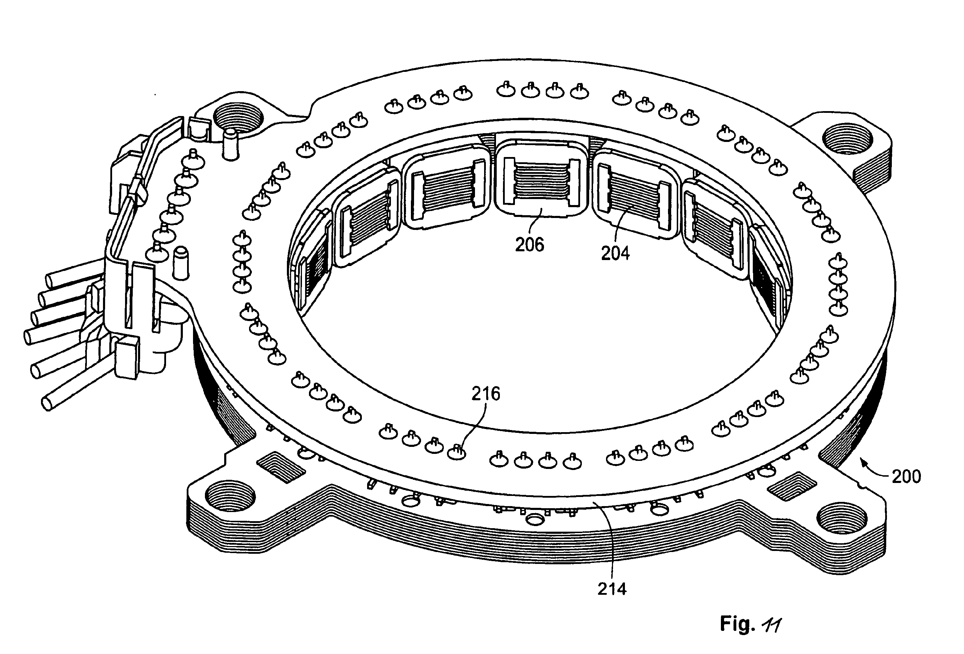

Each coil has a coil body 208 formed from electrically insulating materials such as plastics. Onto this coil body, an electrically conductive winding, for instance a wire 210 is wound. For interconnecting the coils and also for connecting same to external components such as the supply voltages and the measuring circuits, these wires are fixed at contacts 212. As may be derived from Figure 10, the contacts 212 of the wires are pointing upwards in order to be connected electrically. This is done as shown in Figure 11 by means of e.g. a printed circuit board, PCB, 214 which carries interconnecting leads and is connected to the contacts 212 by means of e.g. a solder connection 216.

These conventional arrangements, however, suffer from several severe problems. Firstly, the conventional resolver 200 of Figure 11 is too thick for several fields of application, and the height is mostly determined by the dimensions of the coils and the printed circuit board connections. Furthermore, in the arrangement of Figure 11, a high number of solder points 216 are provided which could fail over time, at extremely high temperatures and excessive vibrations.

The manufacturing of the conventional reluctance resolvers, furthermore, requires too high expenditure and assembly times. Finally, there are applications, where the resolver should work in oil from the gearbox. However, the combination of a printed circuit board having the solder points 216 shown in Figure 11, could fail when being in contact with certain aggressive oils.

JP 2008-089305 A discloses a coil type magnetostrictive torque sensor which uses multilayered flexible substrates with wiring layers having a plurality of coils thereon. These multilayer coil structures have an essentially rectangular outline and are mounted to the inner surface of two half shells of a cylindrical magnetic core which surrounds the outer surface of a rotary shaft.

DE 4233086 A1 discloses a layered coil and a method for fabricating same. The layered coil has a plurality of coil leads which are formed on planar insulating layers so that connecting regions project from peripheral regions and from and inner opening of each layer. The layers are stacked between two ferrite cores. Each of the cores has a protrusion which is arranged centrally and extends through the openings of the coil layers. The protruding leads are connected to each other and to outer terminals as required.

GB 2272110 A relates to a coil that contains a winding part and a core. The winding part is formed by laminating plural sheets, each with a winding pattern. Plural winding patterns are formed on at least one sheet. Each of the winding patterns has a different number of turns, and the winding patterns are formed around the core so as to be co-axial in the same winding direction. The winding patterns formed on the other sheets are connected via a through-hole and an end of the winding pattern is connected to a protruding portion formed at the outside edges of the sheet. A terminal board connection arrangement is disclosed and winding covers are used against dusty environments. Terminals are formed by bending protruding portions of the laminated sheets.

The present invention aims at overcoming the above outlined problems connected with conventional reluctance resolvers, and solves the problem of providing an improved coil structure, magnetic core and angle sensor, which is robust and reliable and can be fabricated in a particularly economic and time saving manner.

This object is solved by the subject matter of the independent claims. Advantageous embodiments of the present invention are the subject matter of the dependent claims.

The present invention is based on the idea that a particularly simple and space saving electromagnetic coil structure can be provided by forming an electrically conductive winding as a flat conductive track which is carried by a flexible electrically insulating carrier, and by forming at least one opening in this coil structure for receiving a magnetic flux guiding element of the magnetic core. Such a coil structure can be fabricated by means of well established flexible printed circuit board technologies. In comparison to the arrangements using separate coil bodies carrying wire wound coils thereon, the fabrication is particularly simple and economic.

Furthermore, the inventive use of a flexible printed circuit board with integrated flat coils allows for a considerable reduction of the required space. The flux guiding element which is extending through the opening of the flat conductive track guides the magnetic flux in a way that the functioning of the inventive system does not differ from the one of conventional systems. Alternatively, also cores without a flux guiding element (also referred to as poles or teeth) can be fabricated by using the flat band coils structure according to the present invention.

In order to provide enough turns of the winding and on the other hand to arrange the coil structure in a particularly space saving way, the coil structure in a mounted state is bent at least once to have a three dimensional form. In particular, the coil structure is bent in a U-shaped manner to encompass the magnetic core of a stator or rotor.

Although in the following detailed description the coil structure is always shown to comprise more than one winding, it is of course also possible to provide only one flat conductive track if this is necessary for a particular application. Furthermore, in the following always a stator core with teeth on its inner circumference is shown. However, for a person skilled in the art, it is clear that the inventive electro magnetic coil structure may of course also be applied to the outer circumferences of a stator and of course may also be used on a rotor, if same is to be equipped with windings.

For fixing the coil structure at the magnetic core, an adhesive layer may advantageously be provided. Such adhesive layers are known to a person skilled in the art in connection with flexible printed circuit boards. Alternatively or additionally, a mechanical fixing means such as a resilient clip may be pushed over the mounted coil structure in order to keep same in place.

In order to most closely reach the magnetic field characteristics of conventional wire wound coils, the flat conductive track is spirally wound around the opening.

In particular, when using the inventive electromagnetic coil structure in an aggressive environment, it is advantageous that the coil structure further comprises an electrically insulating cover layer for hermetically sealing the flat conductive track.

For several practical applications, for instance, for the reluctance resolver shown in DE 10 2009 021444.5, more than one coil has to be provided on each tooth. Consequently, the electromagnetic coil structure according to the present invention, may comprise a multilayer flexible circuit board assembly, wherein alternating conductive layers are insulated from adjacent ones by electrically insulating layers. Thus, in a particularly easy manner a plurality of coils can be attached to the magnetic core. Alternatively, also more that one electromagnetic coil structure may be assembled separately on a magnetic core.

By combining all coils which are needed for one magnetic core into an integrated flexible circuit board, and by arranging same on an inner or an outer circumference of the magnetic core comprising of a plurality of teeth, which are arranged on the circumference in a way that a plurality of openings encompass a tooth of the magnetic core each, all the coils can be mounted as one single part in one common mounting step. This on the one hand saves time and on the other hand reduces expenditure compared to the costs for keeping single coils on stock. Furthermore, these joint coils do not need to be connected to each other in a separate fabrication step as this is the case with conventional arrangements, but are interconnected already before mounting same on the magnetic core.

In order to be adapted for the inventive electromagnetic coil structure, a magnetic core for carrying at least one such coil structure has a circumferential surface with a polygonal shape. Consequently, the magnetic core does not present a curved surface to the electromagnetic coil structure, and therefore facilitates bending the coil structure to abut partially on the upper and lower surfaces of the magnetic core. In particular, the magnetic core may comprise a plurality of teeth which are arranged to protrude each from a lateral surface of this polygonal shape.

A well established way of fabricating such a magnetic core is by composing same from a plurality of stacked and joint lamellae made from metal sheets.

According to an advantageous embodiment of the present invention, a magneto electronic angle sensor based on the inventive principles has standard connections like crimp connections, a plug connector and/or solder connections or laser connections to provide the electrical contact to external components, whereas the windings of the flat conductive tracks are at least partially connected to each other via electric leads that are integrated within the flexible flat coil structure.

In order to eliminate the cables completely, the flat band coil structure can comprise an accordingly shaped connection region.

The accompanying drawings are incorporated into and form a part of the specification to illustrate several embodiments of present invention. These drawings together with the description serve to explain the principles of the invention. The drawings are merely for the purpose of illustrating preferred and alternative examples of how the invention can be made and used, and are not to be construed as limiting the invention to only the illustrated and described embodiments. Furthermore, several aspects of the described embodiments may form individually or in different combinations solutions according to the present invention. Further features and advantages will become apparent from the following more particular description of the various embodiments of the invention as illustrated in the accompanying drawings in which like reference numbers refer to like elements, and wherein:
- **Figure 1**: shows a schematic perspective view of a magnetic core carrying an electromagnetic coil structure thereon;
- **Figure 2**: shows the coil structure of Figure 1 before mounting same onto the core;
- **Figure 3**: shows a perspective view of the magnetic core shown in Figure 1;
- **Figure 4**: illustrates the mounting of the coil structure before performing the bending step;
- **Figure 5**: shows an alternative fixing means;
- **Figure 6**: illustrates another form of coil structure mounted on the magnetic core;
- **Figure 7**: illustrates the coil structure of Figure 6 before being mounted on the magnetic core;
- **Figure 8**: shows the winding of the coil structure of Figure 6 in detail;

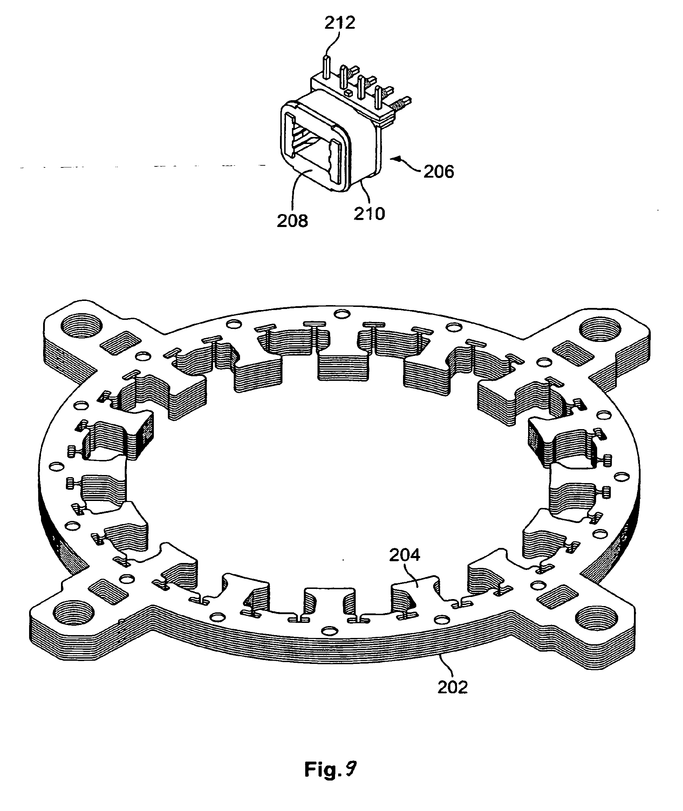

- **Figure 9**: shows a conventional magnetic core and a wire wound coil;
- **Figure 10**: shows the core of Figure 9 during mounting the coils;
- **Figure 11**: shows a conventional reluctance resolver after the soldering of a PCB.

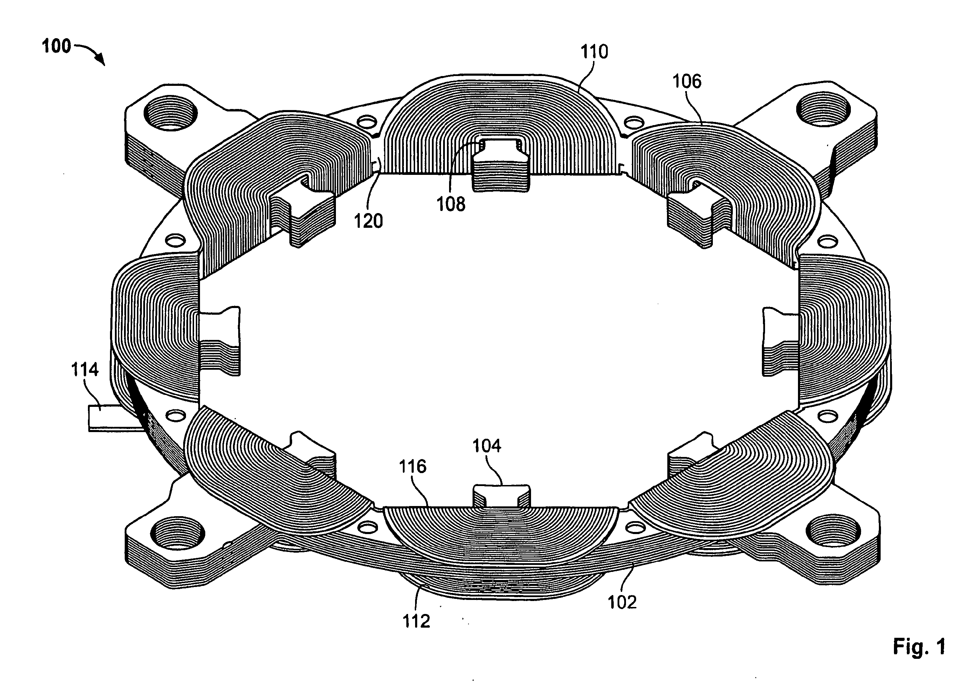

Referring now to the drawings, Figure 1 shows a stator 100 with a coil structure 106 mounted thereon according to the present invention. The stator 100 comprises a magnetic core 102 with eight teeth 104 provided thereon, also referred to as poles or magnetic flux guiding elements. A coil structure 106 is mounted on the magnetic core 102 in such a way that the teeth 104 extend through openings 108 provided at the coil structure 106 around the openings 108, the coil structure 106 comprising flat conductive tracks 110 or wire-wound coils that are integrated into the PCB, which here in particular are formed to be spirally wound around the opening and thus around the tooth 104.

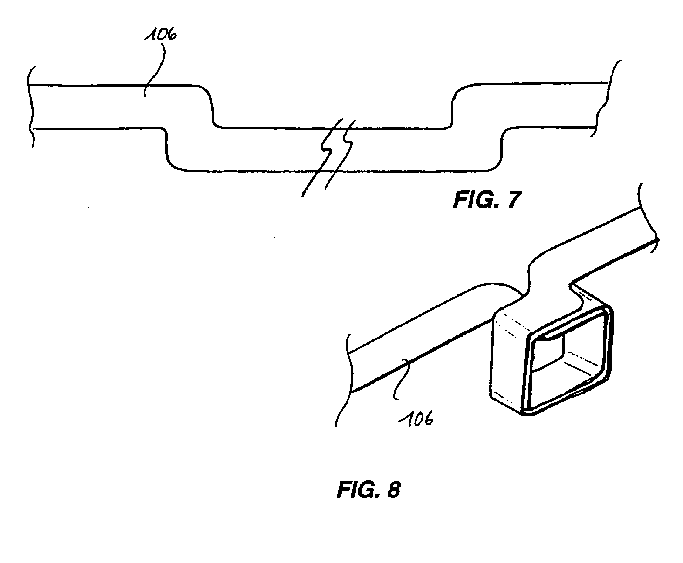

In the embodiment shown, the flat conductive tracks 110 are shaped to form one electrically conductive winding around each tooth 104. The flat conductive tracks 110 are fabricated on a flexible electrically insulating carrier 112, as may be derived from Figure 1. When comparing the stator 100 to the corresponding resolver structure 200 of Figure 7, the arrangement according to the present invention has a much lower height than all conventional structures while maintaining essentially the same functionality.

Furthermore, as it is known for a person skilled in the art, according to the principles of a flexible printed circuit board, FPCB, technology, the coil structure 106 may also be formed as a multilayer FPCB comprising more than one coil at the location of each tooth and also already providing the interconnections between the various coils.

In the embodiment shown in Figure 1, only one connecting region 114 has to be provided for allowing the connection to external components via standard connection technologies. The connecting region 114 carries several terminals which may either be soldered, lasered or crimp-connected to these components, which are in particular the power supply and also the voltage measuring devices.

In order to provide windings with the desired number of turns around each tooth 104, the coil structure 106 is bent to abut on the upper and lower surface of the magnetic core 102 with a part of the coil structure surface.

In order to facilitate the above mentioned bending of the coil structure 106, the inner circumference of the magnetic core 102 has a polygonal rather than a circular cross section, so that straight edges 116 are presented to a coil structure for bending same around it.

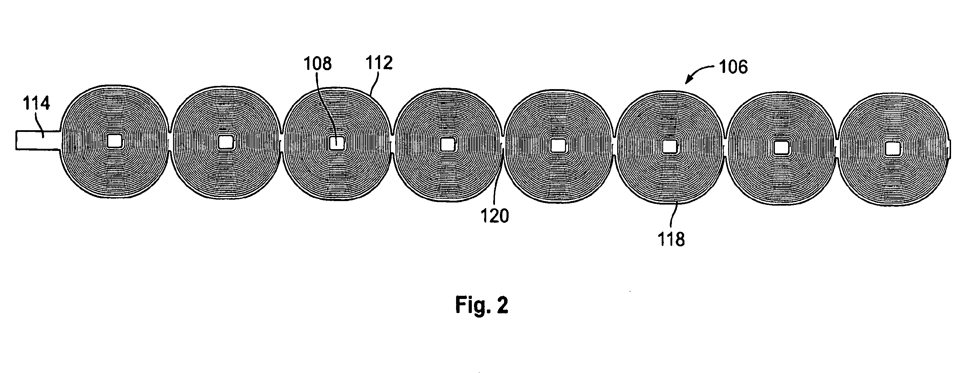

Figure 2 shows the coil structure 106 of Figure 1 before it is mounted on the magnetic core 102. This is the form in which the coil structure 106 may be kept on stock and according to an advantageous embodiment this construction 106 already contains all necessary leads for interconnecting the individual coil elements 118 in the desired pattern to each other. To this end, the coil structure 106 may have several flexible insulating layers with embedded structured metal leads.

Furthermore, all metal parts of the coil structure are preferably hermetically sealed by the insulating material. As such a material, all commonly used laminate materials, such as polyimide or polyester films with layers of copper as the electrically conductive leads are suitable, as well as a resist, e.g. a solder mask. Furthermore, additional heat activateable or other adhesives may be provided for attaching the coil structure 106 to the magnetic core 102.

All terminals that have to be accessible from the outside are to be contacted at the connecting region 114. The openings 108 are formed having an essentially rectangular shape to match the cross section of the teeth 104. Of course, all other necessary shapes of openings 108 may also be used.

Furthermore, a multilayer flexible printed circuit board structure may also be designed to comprise more than one coil element 118 at the location of one or more teeth 104. Alternatively or additionally, two or more coil structures 106 may be applied to the magnetic core 102 in order to form the stator 100 according to the present invention.

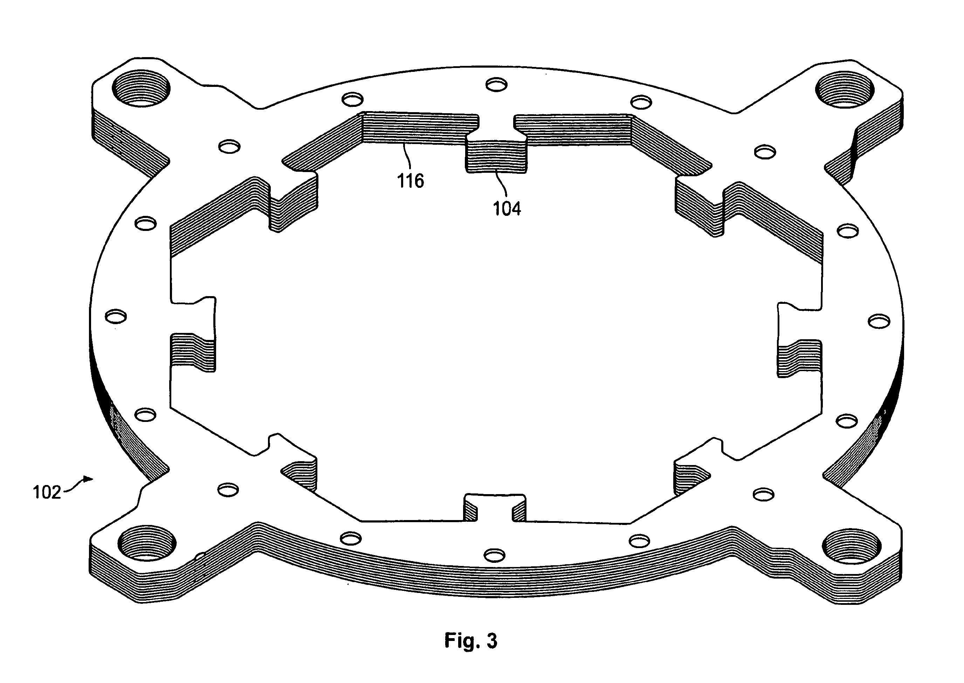

In Figure 3, a magnetic core 102 according to the present invention is shown. The core 102 is formed by a plurality of stacked and joint metal sheets, which are produced by a stamping step. According to the present invention, the inner circumference of the magnetic core 102 has a polygonal cross section so that each tooth 104 extends from a flat rather than a curved surface. Thus, straight edges 116 are present for facilitating the bending of each coil element 118 away from the inner circumference of the core 102 towards the upper and lower surfaces.

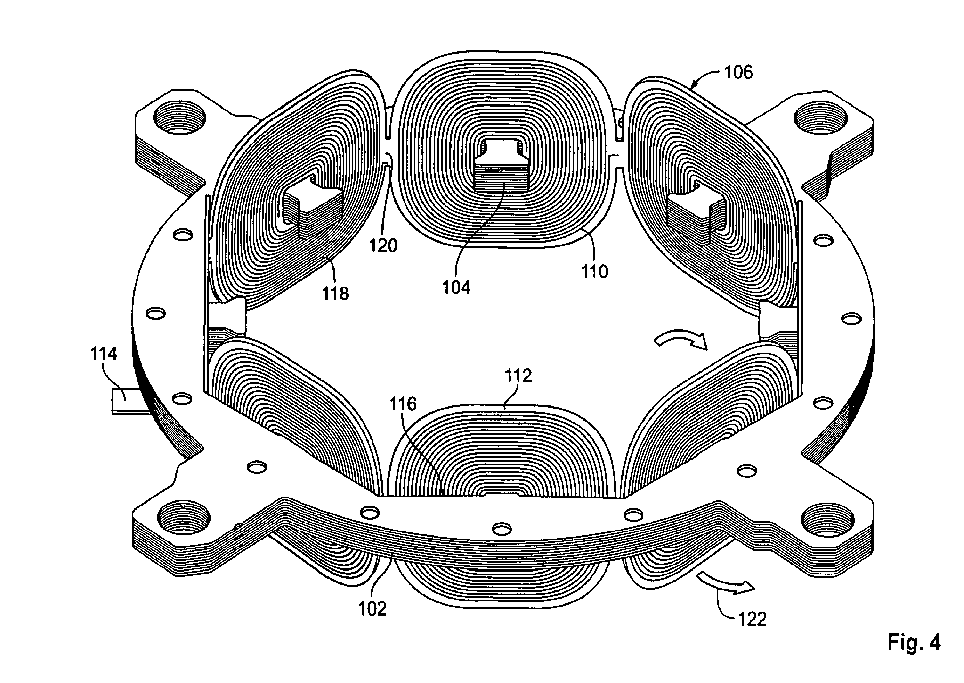

Figure 4 shows the mounting of the coil structure 106 on the magnetic core 102. Each coil element is positioned on the belonging tooth 104 in such a way that the tooth 104 extends through the opening 108. Each coil element 118 is connected to the next one with a chaining region 120 that is smaller than the surface of the coil element 118 and thus can be very easily bent to fit to the corners of the polygonal inner surface of the magnetic core 102.

After the coil structure 106 is fitted around the inner circumference of the magnetic core 102, in a next fabrication step, the upper and the lower parts of the coil elements which extend over the thickness of the magnetic core 102 are bent away from the centre of the magnetic core 102 as indicated by the arrows 122. Those surfaces which come into contact with the surface of the magnetic core 102 may optionally be covered with an adhesive for fixing the coil structure 106 more firmly on the magnetic core 102.

The arrangement according to the present invention facilitates the fabrication and assembly of a stator for a reluctance resolver by integrating coil elements into a flexible printed circuit board, thus eliminating the need of separate coils and the necessity of providing connections through an additional printed circuit board. By assembling the flexible printed circuit board with its openings encompassing the teeth, and folding same over the stator package, the total thickness of the resolver can be minimized and the required space is thus significantly reduced compared to a solution with separate coils.

Consequently, the reliability of the device can be enhanced in comparison to conventional structures where, for instance, for an arrangement with four terminals at eight poles, 32 connections have to be provided between the individual coils and the printed circuit board.

In particular, when applied in environments with excessive vibration, such as in the automotive field, the reliability can be enhanced.

Furthermore, by hermetically sealing all metal parts of the coil structure against the outside, the resistance against oil or water can be enhanced. The production time and costs may be eliminated because no connections between the individual coils and the printed circuit board have to be established as a separate fabrication step. The flexible printed circuit board with the integrated coil elements can simply be assembled as explained above.

Moreover, all costs for preparing separate coils with moulding steps, winding steps and soldering steps can be eliminated. Furthermore, by producing the inventive flexible printed circuit board as a band that is applied around the inner diameter of the core 102 rather than fabricating a printed circuit board which extends in a plane across the rotational axis of the rotor, material waste can be effectively avoided. In the arrangement shown in Figure 11, the whole central area of the printed circuit board 214 has to be cut out and constitutes waste, whereas a flexible printed circuit board can be produced for all desired diameters of the magnetic core without any material waste.

Finally, the thickness of the resolver can be reduced by using the coils which are integrated in the flexible printed circuit board, which can be folded around the stator package. Far thinner resolvers are possible, thus opening a wide field of applications. The present invention may be used as already mentioned with resolvers and syncros and angular sensors in general.

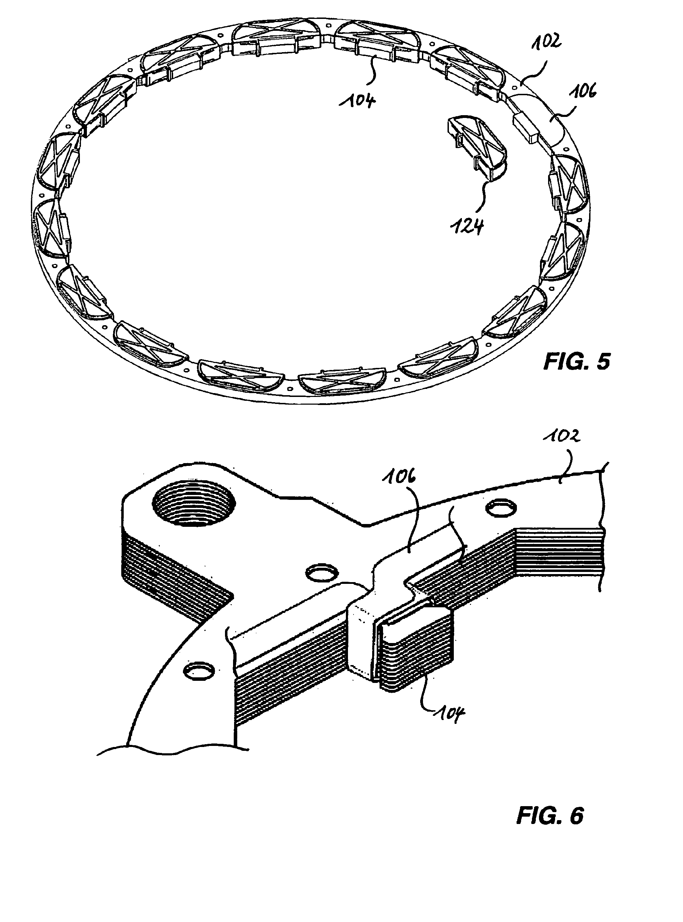

An alternative way of fixing the coil structure 106 is shown schematically in Figure 5. Here moulded resilient clips are provided as fixing means 124 and are pushed over the coil structure 106 after it has been mounted on the magnetic core 102. These clips 124 may for instance be formed from an electrically insulating plastic material.

Figure 6 shows another form of a flat band coil structure 106, which is wound around the teeth 104 of the magnetic core 102. This embodiment has the advantage of generating a magnetic field which closely resembles the one generated by conventional wire wound coils, and can be fabricated in a particularly simple way.

Figure 7 depicts the coil structure 106 of Figure 6 before being wound around the teeth 104 and Figure 8 shows an example of how the coil structure 106 can be wound. Of course, more or less turns than the shown two turns can be provided as well.

Finally, it has to be mentioned that the coil structures 106 according to the present invention can also be mounted on a magnetic core 102, where no teeth 104 are provided. When dispensing with the stator poles, a round or polygonal stator core 102 is used with just the flexible band constituting the coil structure 102 on it. Depending of the position of the rotor, more or less windings would be coupled with the magnetic field, thus generating the desired angle indicating signal.

**REFERENCE NUMERALS**

| **Reference Numeral** | **Description** |
|---|---|
| 100 | Reluctance resolver stator |
| 102 | Magnetic core |
| 104 | Tooth |
| 106 | Coil structure |
| 108 | Opening |
| 110 | Flat conductive track |
| 112 | Flexible carrier |
| 114 | Connecting region |
| 116 | Straight edge |
| 118 | Coil element |
| 120 | Chaining region |
| 122 | Direction of bending |
| 124 | Fixing means |
| 200 | Conventional reluctance resolver stator |
| 202 | Conventional magnetic core |
| 204 | Conventional tooth |
| 206 | Conventional coil |
| 208 | Conventional coil body |
| 210 | Conventional wire |
| 212 | Conventional contacts |
| 214 | Conventional PCB |
| 216 | Conventional solder contact |

## Claims

1. Magnetic core with at least one electromagnetic coil structure, said coil structure (106) comprising:
at least one electrically conductive winding formed as a flat conductive track (110);
at least one flexible electrically insulating carrier (112) for carrying said winding;
wherein said coil structure (106) is mounted on said core (102) to induce and/or receive a magnetic flux in said core,
said magnetic core (102) comprising a plurality of teeth (104) arranged on an inner or an outer circumference of the magnetic core (102), wherein said coil structure (106) comprises a plurality of openings (108) which are formed to encompass a tooth (104) of the magnetic core (102) each, and wherein a part of said flat conductive track (110) is spirally wound around each of said openings (108).

2. Magnetic core according to claim 1, wherein said coil structure (106) is bent at least once to have a three-dimensional form.

3. Magnetic core according to claim 2, wherein said coil structure (106) is bent twice to encompass said magnetic core (102) in a U-shaped manner.

4. Magnetic core according to claim 1, wherein said coil structure (106) is bent several times to reduce the length of said coil structure (106) for a reduced diameter of said magnetic core.

5. Magnetic core according to one of the preceding claims, said electromagnetic coil structure (106) further comprising an adhesive layer and/or a mechanical fixing element (124) for fixing said coil structure (106) at said magnetic core (102).

6. Magnetic core according to one of the preceding claims, wherein said coil structure (106) further comprises an electrically insulating cover layer or a resist for hermetically sealing said flat conductive track (110).

7. Magnetic core according to one of the preceding claims, wherein said coil structure (106) comprises a multilayer flexible circuit board assembly, alternating conductive layers being insulated from adjacent ones by electrically insulating layers.

8. Magnetic core according to one of the preceding claims, wherein a plurality of electrically conductive windings is provided around the same opening (108).

9. Magnetic core according to one of the preceding claims, wherein a circumferential surface whereto said electromagnetic coil structure (106) is mounted has a polygonal shape.

10. Magnetic core according to claim 9, comprising a plurality of teeth (104) which are arranged to protrude each from a lateral surface of said polygonal shape.

11. Magnetic core according to one of the preceding claims, being formed by a plurality of stacked and joined lamellae made from metal sheets.

12. Magneto electronic angle sensor with an at least partially ferromagnetic stator and an at least partially ferromagnetic rotor, said rotor being opposed to said stator forming a ring shaped air gap there between, wherein the reluctance in said air gap varies due to a shape of the rotor which varies along the rotor's circumference periodically if the rotor rotates around a rotation axis,
with a magnetic flux sender arranged at said stator, for generating via at least one pole pair a predetermined magnetic flux distribution within said air gap;
with a magnetic flux detector arranged at said stator, for detecting the intensity of the magnetic field by means of at least two signal pole pairs being off-set to each other by a predetermined angle, wherein from both detector signals an angle value can be derived for the relative position of the rotor with respect to the stator;
wherein said stator is formed by a magnetic core (102) according to one of the preceding claims, said magnetic flux sender and said magnetic flux detector comprising windings that are fabricated as one or more of said coil structures (106).

13. Magneto electronic angle sensor according to claim 12, wherein at least two separate coil structures (106) are mounted on said magnetic core.

14. Magneto electronic angle sensor according to claim 12 or 13, wherein said windings are at least partly connected to each other via electric leads integrated within said coil structure (106) and wherein connections to external components are effected by an electrical connection arranged at a connecting region (114).

15. Magneto electronic angle sensor according to claim 14, wherein said connecting region (114) is extended to a location of the connection to said external components.

16. Method for fabricating a magneto electronic angle sensor, said method comprising the following steps:
providing a magnetic core which has a plurality of teeth protruding from a circumferential surface having a polygonal cross section;
providing at least one electromagnetic coil structure with at least one electrically conductive winding formed as a flat conductive track and at least one flexible electrically insulating carrier for carrying said winding;
mounting said coil structure on said magnetic core in a way that said teeth penetrate through openings provided at the coil structure and that the coil structure abuts at least on the circumferential surface of the magnetic core.

17. Method according to claim 16, further comprising the step of bending at least a part of said coil structure in way that it abuts to a second surface of the magnetic core, the second surface extending across the circumferential surface of the magnetic core.

## Patentansprüche

1. Magnetkern mit wenigstens einer elektromagnetischen Spulenstruktur, wobei die Spulenstruktur (106) umfasst:
wenigstens eine elektrisch leitende Wicklung, die als eine flache leitende Bahn (110) ausgebildet ist;
wenigstens einen flexiblen elektrisch isolierenden Träger (112), der die Wicklung trägt;
wobei die Spulenstruktur (106) an dem Kern (102) angebracht wird, um einen Magnetfluss in dem Kern zu induzieren und/oder zu empfangen,
der Magnetkern (102) eine Vielzahl von Zähnen (104) umfasst, die an einem Innen- oder einem Außenumfang des Magnetkerns (102) angeordnet sind, wobei die Spulenstruktur (106) eine Vielzahl von Öffnungen (108) umfasst, die so ausgebildet sind, dass sie jeweils einen Zahn (104) des Magnetkerns (102) umschließen, und ein Teil der flachen leitenden Bahn (110) spiralförmig um jede der Öffnungen (108) herum gewickelt ist.

2. Magnetkern nach Anspruch 1, wobei die Spulenstruktur (106) wenigstens einmal so gebogen ist, dass sie eine dreidimensionale Form hat.

3. Magnetkern nach Anspruch 2, wobei die Spulenstruktur (106) zweimal gebogen ist und den Magnetkern (102) U-förmig umschließt.

4. Magnetkern nach Anspruch 1, wobei die Spulenstruktur (106) mehrmals gebogen ist, um die Länge der Spulenstruktur (106) zu reduzieren und einen Durchmesser des Magnetkerns zu reduzieren.

5. Magnetkern nach einem der vorangehenden Ansprüche, wobei die elektromagnetische Spulenstruktur (106) des Weiteren eine Klebeschicht und/oder ein mechanisches Befestigungselement (124) zum Befestigen der Spulenstruktur (106) an dem Magnetkern (102) umfasst.

6. Magnetkern nach einem der vorangehenden Ansprüche, wobei die Spulenstruktur (106) des Weiteren eine elektrisch isolierende Abdeckschicht oder ein Resist zum hermetischen Abdichten der flachen leitenden Bahn (110) umfasst.

7. Magnetkern nach einem der vorangehenden Ansprüche, wobei die Spulenstruktur (106) eine mehrschichtige flexible Leiterplattenanordnung umfasst und wechselnde leitende Schichten durch elektrisch isolierende Schichten gegenüber angrenzenden Schichten isoliert sind.

8. Magnetkern nach einem der vorangehenden Ansprüche, wobei eine Vielzahl elektrisch leitender Wicklungen um die gleiche Öffnung (108) herum vorhanden sind.

9. Magnetkern nach einem der vorangehenden Ansprüche, wobei eine Umfangsfläche, an der die elektromagnetische Spulenstruktur (106) angebracht ist, eine polygonale Form hat.

10. Magnetkern nach Anspruch 9, der eine Vielzahl von Zähnen (104) umfasst, die so angeordnet sind, dass sie jeweils von einer seitlichen Fläche der polygonalen Form vorstehen.

11. Magnetkern nach einem der vorangehenden Ansprüche, der durch eine Vielzahl übereinander geschichteter und verbundener Lamellen gebildet wird, die aus Metallplatten bestehen.

12. Magneto-elektronischer Winkelsensor mit einem wenigstens teilweise ferromagnetischen Stator und einem wenigstens teilweise ferromagnetischen Rotor, wobei der Rotor dem Stator gegenüberliegt und ein ringförmiger Luftspalt zwischen ihnen gebildet wird, die Reluktanz in dem Luftspalt aufgrund einer Form des Rotors variiert, die an dem Umfang des Rotors entlang periodisch variiert, wenn sich der Rotor um eine Drehachse herum dreht,
wobei ein Magnetfluss-Sender an dem Stator angeordnet ist, um über wenigstens ein Polpaar eine vorgegebene Magnetflussverteilung in dem Luftspalt zu erzeugen;
ein Magnetfluss-Detektor an dem Stator angeordnet ist, um die Stärke des Magnetfeldes mittels wenigstens zweier Signal-Polpaare zu erfassen, die um einen vorgegebenen Winkel zueinander versetzt sind, und von beiden Detektorsignalen ein Winkelwert für die relative Position des Rotors in Bezug auf den Stator hergeleitet werden kann;
und der Stator durch einen Magnetkern (102) nach einem der vorangehenden Ansprüche gebildet wird und der Magnetfluss-Sender sowie der Magnetfluss-Detektor Wicklungen umfassen, die als eine oder mehrere der Spulenstrukturen (106) hergestellt werden.

13. Magneto-elektronischer Winkelsensor nach Anspruch 12, wobei wenigstens zwei separate Spulenstrukturen (106) an dem Magnetkern angebracht sind.

14. Magneto-elektronischer Winkelsensor nach Anspruch 12 oder 13, wobei die Wicklungen über elektrische Leitungen, die in die Spulenstruktur (106) integriert sind, wenigstens teilweise miteinander verbunden sind und Verbindungen mit externen Komponenten mittels einer elektrischen Verbindung hergestellt werden, die an einem Verbindungsbereich (114) angeordnet ist.

15. Magneto-elektronischer Winkelsensor nach Anspruch 14, wobei der Verbindungsbereich (114) zu einer Position der Verbindung mit den externen Komponenten ausgedehnt ist.

16. Verfahren zum Herstellen eines magneto-elektronischen Winkelsensors, wobei das Verfahren die folgenden Schritte umfasst:
Bereitstellen eines Magnetkerns, der eine Vielzahl von Zähnen aufweist, die von einer Umfangsfläche vorstehen, die einen polygonalen Querschnitt hat;
Bereitstellen wenigstens einer elektromagnetischen Spulenstruktur mit wenigstens einer elektrisch leitenden Wicklung, die als eine flache leitende Bahn ausgebildet ist, und wenigstens einem flexiblen elektrisch isolierenden Träger zum Tragen der Wicklung;
Anbringen der Spulenstruktur an dem Magnetkern so, dass die Zähne durch an der Spulenstruktur vorhandene Öffnungen hindurch eindringen und dass die Spulenstruktur wenigstens an der Umfangsfläche des Magnetkerns anliegt.

17. Verfahren nach Anspruch 16, das des Weiteren den Schritt umfasst, in dem wenigstens ein Teil der Spulenstruktur so gebogen wird, dass er an einer zweiten Fläche des Magnetkerns anliegt, wobei sich die zweite Fläche über die Umfangsfläche des Magnetkerns erstreckt.

## Revendications

1. Noyau magnétique avec au moins une structure de bobine électromagnétique, ladite structure de bobine (106) comprenant :
au moins un enroulement électriquement conducteur conformé comme une piste conductrice plane (110) ;
au moins un porteur électriquement isolant flexible (112) pour porter ledit enroulement ;
dans lequel ladite structure de bobine (106) est montée sur ledit noyau (102) pour induire et/ou recevoir un flux magnétique dans ledit noyau,
ledit noyau magnétique (102) comprenant une pluralité de dents (104) agencées sur une circonférence interne ou externe du noyau magnétique (102), dans lequel ladite structure de bobine (106) comprend une pluralité d'ouvertures (108) qui sont formées pour entourer chacune une dent (104) du noyau magnétique (102), et dans lequel une partie de ladite piste conductrice plane (110) est enroulée en spirale autour de chacune desdites ouvertures (108).

2. Noyau magnétique selon la revendication 1, dans lequel ladite structure de bobine (106) est courbée au moins une fois pour adopter une forme tridimensionnelle.

3. Noyau magnétique selon la revendication 2, dans lequel ladite structure de bobine (106) est courbée deux fois pour entourer ledit noyau magnétique (102) selon une forme en U.

4. Noyau magnétique selon la revendication 1, dans lequel ladite structure de bobine (106) est courbée plusieurs fois pour réduire la longueur de ladite structure de bobine (106) de manière à obtenir un diamètre réduit dudit noyau magnétique.

5. Noyau magnétique selon l'une des revendications précédentes, ladite structure de bobine électromagnétique (106) comprenant en outre une couche adhésive et/ou un élément de fixation mécanique (124) pour fixer ladite structure de bobine (106) audit noyau magnétique (102).

6. Noyau magnétique selon l'une des revendications précédentes, dans lequel ladite structure de bobine (106) comprend en outre une couche de revêtement électriquement isolante ou une résistance pour sceller hermétiquement ladite piste conductrice plane (110).

7. Noyau magnétique selon l'une des revendications précédentes, dans lequel ladite structure de bobine (106) comprend un assemblage à circuit imprimé flexible multicouche, les couches conductrices alternées étant isolées des couches adjacentes par des couches électriquement isolantes.

8. Noyau magnétique selon l'une des revendications précédentes, dans lequel une pluralité d'enroulements électriquement conducteurs est pourvue autour de la même ouverture (108).

9. Noyau magnétique selon l'une des revendications précédentes, dans lequel une surface circonférentielle sur laquelle ladite structure de bobine électromagnétique (106) est montée présente une forme polygonale.

10. Noyau magnétique selon la revendication 9, comprenant une pluralité de dents (104) qui sont agencées pour ressortir chacune d'une surface latérale de ladite forme polygonale.

11. Noyau magnétique selon l'une des revendications précédentes, formé par une pluralité de lamelles empilées et jointes constituées de feuilles métalliques.

12. Capteur d'angle magnétoélectrique avec un stator au moins partiellement ferromagnétique et un rotor au moins partiellement ferromagnétique, ledit rotor étant opposé audit stator pour former entre eux un entrefer de forme annulaire, dans lequel la réluctance dans ledit entrefer varie du fait de la forme du rotor, qui varie périodiquement le long de la circonférence du rotor si le rotor tourne autour d'un axe de rotation,
avec un émetteur de flux magnétique agencé sur ledit stator pour générer, via au moins une paire de pôles, une distribution de flux magnétique prédéterminée dans ledit entrefer ;
avec un détecteur de flux magnétique agencé sur ledit stator pour détecter l'intensité du champ magnétique à l'aide du déphasage mutuel d'un angle prédéterminé d'au moins deux paires de pôles de signal, dans lequel une valeur d'angle peut être dérivée à partir des deux signaux de détecteur pour la position relative du rotor par rapport au stator ;
dans lequel ledit stator est formé par un noyau magnétique (102) selon l'une des revendications précédentes, ledit émetteur de flux magnétique et ledit détecteur de flux magnétique comprenant des enroulements qui sont fabriqués sous forme d'une ou plusieurs desdites structures de bobinage (106).

13. Capteur d'angle magnétoélectrique selon la revendication 12, dans lequel au moins deux structures de bobinage séparées (106) sont montées sur ledit noyau magnétique.

14. Capteur d'angle magnétoélectrique selon la revendication 12 ou 13, dans lequel lesdits enroulements sont au moins partiellement connectés entre eux via des conducteurs électriques intégrés dans ladite structure de bobine (106), et dans lequel des connexions à des composants externes sont effectuées par une connexion électrique agencée dans une zone de connexion (114).

15. Capteur d'angle magnétoélectrique selon la revendication 14, dans lequel ladite zone de connexion (114) s'étend jusqu'à un emplacement de la connexion auxdits composants externes.

16. Procédé de fabrication d'un capteur d'angle magnétoélectrique, ledit procédé comprenant les étapes suivantes :
fourniture d'un noyau magnétique qui comporte une pluralité de dents ressortant d'une surface circonférentielle qui présente une section transversale polygonale ;
fourniture d'au moins une structure de bobine électromagnétique avec au moins un enroulement électriquement conducteur formé comme une piste conductrice plane et au moins un porteur électriquement isolant flexible pour porter ledit enroulement ;
montage de ladite structure de bobine sur ledit noyau magnétique de telle sorte que lesdites dents pénètrent dans des ouvertures pourvues sur la structure de bobine et que la structure de bobine vient à butée contre au moins la surface circonférentielle du noyau magnétique.

17. Procédé selon la revendication 16, comprenant en outre l'étape de flexion d'au moins une partie de ladite structure de bobine de telle sorte qu'elle vient à butée contre une deuxième surface du noyau magnétique, la deuxième surface s'étendant sur la surface circonférentielle du noyau mag nétique.
